(19) Europäisches Patentamt / European Patent Office / Office européen des brevets

(11) **EP 3 836 238 A1**

(12) **DEMANDE DE BREVET EUROPEEN**

(43) Date de publication:
**16.06.2021 Bulletin 2021/24**

(51) Int Cl.:
**H01L 41/04** (2006.01)

(21) Numéro de dépôt: **19216194.1**

(22) Date de dépôt: **13.12.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(71) Demandeur: **UFC (Universite de Franche-Comte)**
**25030 Besancon (FR)**

(72) Inventeurs:
• **LUTZ, Philippe**
  **25870 CHATILLON LE DUC (FR)**
• **RAKOTONDRABE, Micky**
  **25000 BESANCON (FR)**
• **BAFUMBA LISELI, Joël**
  **93320 Les Pavillons sous Bois (FR)**

(74) Mandataire: **Vidon Brevets & Stratégie**
**16B, rue de Jouanet**
**BP 90333**
**35703 Rennes Cedex 7 (FR)**

(54) **PROCÉDÉS D ESTIMATION ET DE CORRECTION D'UNE DÉFORMATION D'UN ACTIONNEUR PIÉZOÉLECTRIQUE, PRODUITS PROGRAMME D'ORDINATEUR, DISPOSITIFS ET SYSTÈME CORRESPONDANTS**

(57) L'invention concerne un procédé d'estimation d'une déformation d'un actionneur piézoélectrique. La déformation résulte d'une application d'une tension de commande sur une électrode de contrôle de l'actionneur. Le procédé d'estimation comprend :
- une application (E210) d'une tension de détection sur l'électrode de contrôle à une fréquence de détection non comprise dans un spectre de la tension de commande ; et
- une mesure (E220) d'un courant de détection traversant l'électrode de contrôle à la fréquence de détection délivrant une amplitude mesurée du courant de détection.

Le procédé d'estimation comprend une estimation (E230) de la déformation par mise en œuvre d'un estimateur basé sur un mappage préalablement obtenu faisant la correspondance directe entre au moins une amplitude du courant de détection et une valeur correspondante de la déformation de l'actionneur piézoélectrique, l'estimateur étant appliqué à l'amplitude mesurée du courant de détection.

[Fig. 2]

## Description

### Domaine de l'invention

Le domaine de l'invention est celui du contrôle des actionneurs piézoélectriques.

Plus précisément, l'invention concerne des procédés d'estimation et de correction de la déformation d'un tel actionneur piézoélectrique.

L'invention trouve ainsi de nombreuses applications dans tous les domaines dans lesquels les actionneurs piézoélectriques sont utilisés, notamment, mais non exclusivement, dans les domaines nécessitant un positionnement mécanique de précision (e.g. dans le domaine des dispositifs médicaux implantables, de la microscopie à sonde à balayage, etc.) ou dans les domaines nécessitant un contrôle de débit de précision (e.g. dans le domaine des injecteurs de carburants, des vannes de dosage, des imprimantes à jet d'encre, etc.).

### Art antérieur et ses inconvénients

La demande actuelle croissante en miniaturisation des produits manufacturés s'accompagne de la nécessité de réaliser différentes tâches du type micro-usinage, micro-assemblage et micromanipulation. De telles tâches nécessitent un positionnement mécanique de très grande précision, ainsi qu'une résolution pouvant descendre au nanomètre.

Les technologies piézoélectriques jouent un rôle fondamental dans les applications de positionnement ou les exigences de résolution sont micro ou nanométriques. La haute résolution, la large bande passante, la petite taille et la grande densité de force que fournissent les matériaux piézoélectriques font de ceux-ci d'excellents candidats pour le développement de systèmes de positionnement qui évoluent à l'échelle micro ou nanométrique.

Afin de pouvoir utiliser les actionneurs piézoélectriques avec précision dans des applications à une telle échelle, il est nécessaire d'asservir certaines grandeurs physiques associées aux actionneurs en question (e.g. la déformation, ou le positionnement) via une boucle de contrôle utilisant un retour d'information.

Dans ce but, une première approche consiste à utiliser un capteur externe destiné à mesurer la ou les grandeurs à contrôler. Malheureusement, les capteurs externes utilisés pour mesurer avec précision des grandeurs physiques telles que la position et la force ne sont pas parfaitement adaptés à des mesures à l'échelle micro ou nanométrique en raison de leur taille, de leurs performances et du nombre de degrés de liberté à contrôler. Par ailleurs, l'utilisation de capteurs externes supplémentaires entraine nécessairement un surcoût.

Pour répondre à ce besoin de précision sans encombrement ni surcoût, une deuxième approche a été proposée via des techniques dites d'auto-détection, ou « self-sensing » en anglais. L'auto-détection permet l'actionnement d'un dispositif piézoélectrique tout en mesurant sa déformation et/ou la contrainte qui lui est appliquée en utilisant l'actionneur comme son propre capteur. En effet, les matériaux piézoélectriques présentent un couplage électromécanique élevé qui leur permet à la fois de générer un signal électrique sous contrainte mécanique et, inversement, de se déformer sous un champ électrique appliqué. La réversibilité dans le fonctionnement des matériaux piézoélectriques conduit à l'utilisation de ces matériaux à des fins de détection et d'actionnement simultanément.

Plus particulièrement, les techniques d'autodétection sont classées en deux catégories :

1) Selon une première approche, l'auto-détection est basée sur une compensation de l'effet diélectrique de l'actionneur piézoélectrique afin de récupérer le signal issu de sa déformation via l'utilisation d'un dispositif tiers. Dans certaines implémentations, un tel dispositif tiers prend la forme d'un pont de capacités dans lequel l'actionneur piézoélectrique est modélisé par une source de tension dépendante de la déformation. Dans d'autres implémentations, le dispositif tiers prend la forme d'un circuit de compensation de courant antiparallèle lorsque l'actionneur piézoélectrique est modélisé par une source de charge dépendante de la déformation.

2) Selon une deuxième approche, l'auto-détection est basée sur une évaluation du changement des propriétés électriques de l'actionneur piézoélectrique lié à sa déformation. Une telle évaluation se fait par exemple via la mesure de la permittivité relative du matériau de l'actionneur, ou via la mesure de sa capacitance, ou encore via la mesure de la capacitance et résistance simultanément.

Cependant, l'auto-détection basée sur l'effet direct piézoélectrique (première approche précitée) exige un réglage continu et fastidieux du dispositif tiers afin de récupérer le signal lié à la déformation de l'actionneur piézoélectrique.

De même, l'auto-détection basée sur une évaluation du changement des propriétés électriques de l'actionneur piézoélectrique (deuxième approche précitée) nécessite l'utilisation de capteurs souvent encombrants et couteux, ainsi qu'une charge de calculs associée non négligeable.

Il existe ainsi un besoin pour une technique d'estimation et de correction d'une déformation d'un actionneur piézoélectrique nécessitant un nombre réduit de capteurs de mesures.

Il existe un besoin pour qu'une telle technique soit simple à mettre en œuvre et nécessite une charge de calculs limitée.

### Exposé de l'invention

Dans un mode de réalisation de l'invention, il est proposé un procédé d'estimation d'une déformation d'un actionneur piézoélectrique. La déformation résulte d'une application d'une tension de commande sur au moins une électrode de contrôle de l'actionneur piézoélectrique. Le procédé d'estimation comprend :

- une application d'une tension de détection sur ladite au moins une électrode de contrôle, une fréquence de la tension de détection, dite fréquence de détection, étant non comprise dans un spectre de la tension de commande ; et
- une mesure d'un courant de détection traversant ladite au moins une électrode de contrôle à la fréquence de détection délivrant une amplitude mesurée du courant de détection.

Le procédé d'estimation comprend une estimation de la déformation par mise en œuvre d'un estimateur basé sur un mappage préalablement obtenu faisant la correspondance directe, pour la fréquence de détection, entre au moins une amplitude du courant de détection et une valeur correspondante de la déformation de l'actionneur piézoélectrique, l'estimateur étant appliqué à l'amplitude mesurée du courant de détection.

Ainsi, l'invention propose une solution nouvelle et inventive pour estimer la déformation d'un actionneur piézoélectrique.

Plus particulièrement, pour une tension de commande donnée, la déformation obtenue sur l'actionneur piézoélectrique dépend de son état interne. Or, l'impédance vue aux bornes de l'électrode de contrôle est une fonction de l'état interne de l'actionneur piézoélectrique. Ainsi, pour une tension de détection donnée, l'estimation de la déformation à partir du courant de détection mesuré permet une prise en compte implicite de l'impédance vue aux bornes de l'électrode de contrôle et donc de l'état interne de l'actionneur piézoélectrique. L'estimation de la déformation est ainsi plus précise.

Par ailleurs, la mise en œuvre d'un mappage direct entre l'amplitude du courant de détection et la déformation correspondante permet de s'affranchir de mesures complémentaires (e.g. une mesure de la tension de détection telle qu'effectivement appliquée au capteur piézoélectrique), et donc de l'usage des capteurs correspondants, ainsi que de calculs intermédiaires complexes (e.g. pour l'estimation de l'impédance du capteur piézoélectrique à la fréquence de détection).

Selon un mode de réalisation, la mesure d'un courant de détection met en œuvre une transformée de Fourier discrète d'une série de N échantillons temporels du courant de détection.

Ainsi, l'extraction du courant de détection au sein du courant total traversant l'électrode de contrôle et simple et efficace.

Selon un mode de réalisation, la transformée de Fourier discrète est évaluée uniquement à la fréquence de détection.

Ainsi, la charge de calcul est réduite.

Selon un mode de réalisation, l'estimateur est un estimateur linéaire du type OE (pour « Output Error » en anglais) ou un estimateur non-linéaire du type Harmmerstein-Wiener.

Selon un mode de réalisation, la fréquence de détection est différente d'une fréquence de résonance f0 de l'actionneur piézoélectrique, de préférence la fréquence de détection est inférieure à 0,5*f0.

Par exemple, la fréquence de détection est choisie inférieure à 20 kHz pour un actionneur piézoélectrique ayant une fréquence de résonance f0 égale à 40 kHz.

Selon un mode de réalisation, une amplitude de la tension de détection est configurée pour induire une déformation de l'actionneur piézoélectrique à la fréquence de détection présentant une amplitude inférieure à une tolérance prédéterminée.

Par exemple, pour l'actionneur P 885-91 commercialisé par la société PICeramic, une amplitude de 5 mV pour une fréquence de détection de 20 kHz permet de contenir l'amplitude de la déformation de l'actionneur obtenue à la fréquence de 20 kHz à une valeur inférieure à 1 nm.

Dans un mode de réalisation de l'invention, il est également proposé un procédé de correction d'une déformation d'un actionneur piézoélectrique. Le procédé de correction comprend :

- une application d'une tension de commande sur au moins une électrode de contrôle de l'actionneur piézoélectrique induisant la déformation ;
- une estimation de la déformation par mise en œuvre du procédé d'estimation décrit ci-dessus (selon l'un quelconque des modes de réalisation précités) suite à l'application de la tension de commande ;
- une correction de la tension de commande à partir de l'estimation de la déformation délivrant une tension de commande corrigée ; et
- une application de la tension de commande corrigée sur ladite au moins une électrode de contrôle.

L'invention concerne également un programme d'ordinateur comprenant des instructions de code de programme pour la mise en œuvre du procédé d'estimation décrit ci-dessus (selon l'un quelconque des différents modes de réalisation précités) et/ou du procédé de correction décrit ci-dessus (selon l'un quelconque des différents modes de réalisation précités), lorsqu'il est exécuté sur un ordinateur.

Dans un autre mode de réalisation de l'invention, il est proposé un dispositif d'estimation comprenant une machine de calcul reprogrammable ou une machine de calcul dédiée, configurée pour mettre en œuvre les étapes du procédé d'estimation selon l'invention (selon l'un quelconque des modes de réalisation précités).

Ainsi, les caractéristiques et avantages de ce dispositif sont les mêmes que ceux du procédé d'estimation décrit précédemment. Par conséquent, ils ne sont pas détaillés plus amplement.

Dans un autre mode de réalisation de l'invention, il est proposé un dispositif de correction comprenant une machine de calcul reprogrammable ou une machine de calcul dédiée, configurée pour mettre en œuvre les étapes du procédé de correction selon l'invention (selon l'un quelconque des modes de réalisation précités).

Ainsi, les caractéristiques et avantages de ce dispositif sont les mêmes que ceux du procédé de correction décrit précédemment. Par conséquent, ils ne sont pas détaillés plus amplement.

## Liste des figures

D'autres buts, caractéristiques et avantages de l'invention apparaîtront plus clairement à la lecture de la description suivante, donnée à titre de simple exemple illustratif, et non limitatif, en relation avec les figures, parmi lesquelles :

[Fig. 1] illustre un système actionneur asservi en déformation comprenant un actionneur piézoélectrique associé à un dispositif de correction selon un mode de réalisation de l'invention ;

[Fig. 2] illustre les étapes d'un procédé d'estimation de la déformation de l'actionneur piézoélectrique de la Fig. 1 selon un mode de réalisation de l'invention ;

[Fig. 3] illustre les étapes d'un procédé de correction de la déformation de l'actionneur piézoélectrique de la Fig. 1 selon un mode de réalisation de l'invention ;

[Fig. 4] illustre un exemple de structure de dispositif permettant la mise en œuvre des étapes du procédé d'estimation de la Fig. 2 et/ou des étapes du procédé de correction de la Fig. 3 selon un mode de réalisation de l'invention.

## Description détaillée de modes de réalisation de l'invention

Le principe général de l'invention repose, pour l'estimation d'une déformation d'un actionneur piézoélectrique résultant d'une application d'une tension de commande sur une électrode de contrôle de l'actionneur en question, sur la mise en œuvre d'un estimateur basé sur un mappage faisant la correspondance directe (i.e. sans étape de calcul intermédiaire du type calcul d'impédance ou d'une autre grandeur physique associée à l'état interne de l'actionneur piézoélectrique) entre, d'une part, une amplitude d'un courant de détection mesuré sur l'électrode de contrôle de l'actionneur et, d'autre part, une valeur correspondante de la déformation de l'actionneur piézoélectrique. Le courant de détection résulte de l'application d'une tension de détection sur l'électrode de contrôle en question.

Ainsi, une estimation de la déformation est obtenue en s'affranchissant de mesures complémentaires (e.g. une mesure de la tension de détection telle qu'effectivement appliquée au capteur piézoélectrique), et donc de l'usage de capteurs correspondants, ainsi que de calculs intermédiaires complexes (e.g. pour l'estimation de l'impédance du capteur piézoélectrique à la fréquence de détection).

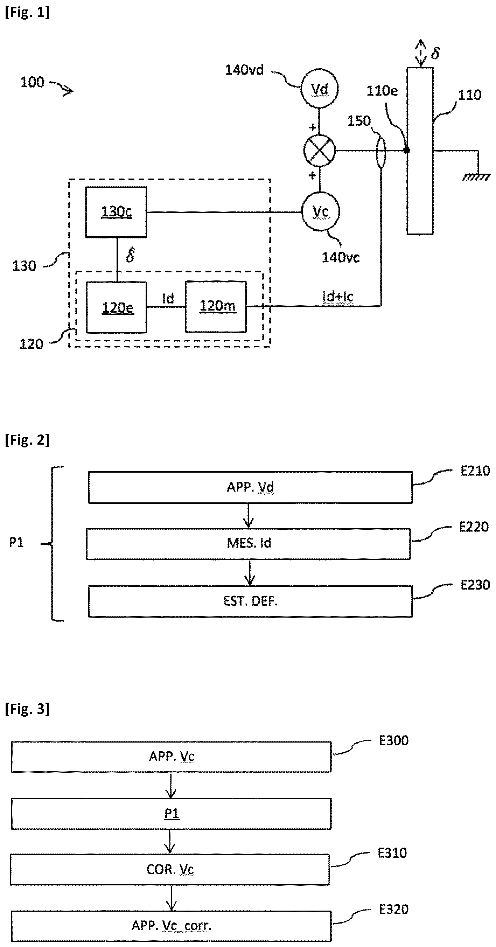

On présente désormais, en relation avec la **Fig. 1** un système 100 actionneur asservi en déformation comprenant un actionneur piézoélectrique 110 associé à un dispositif 130 de correction selon un mode de réalisation de l'invention.

Plus particulièrement, l'actionneur piézoélectrique 110 (e.g. un actionneur P 885-91 commercialisé par la société PICeramic) comprend une électrode 110e de contrôle sur laquelle est appliquée, d'une part, une tension de commande Vc délivrée par une source de tension 140vc et, d'autre part, une tension de détection Vd délivrée par une source de tension 140vd.

Dans d'autres modes de réalisation, l'actionneur piézoélectrique 110 comprend plusieurs électrodes de contrôle. Dans ce cas, la tension de commande Vc est appliquée sur tout ou partie des électrodes de contrôle en question. Il en est de même de la tension de détection Vd.

De retour à la Fig. 1, les tensions de commande Vc et de détection Vd sont sommées afin de délivrer une tension totale appliquée sur l'électrode 110e. La tension de détection Vd est une tension sinusoïdale ayant une fréquence fd, dite fréquence de détection.

En réponse à la tension totale, l'actionneur piézoélectrique 110 se déforme. Une telle déformation se compose, d'une part, d'une première déformation correspondant à la tension de commande Vc et, d'autre part, d'une deuxième déformation, à la fréquence fd de détection, correspondant à la tension de détection Vd.

En pratique, l'amplitude de la tension de détection Vd est sélectionnée de manière à conduire à une déformation supplémentaire négligeable devant la déformation liée à la tension de commande Vc. Par exemple, l'amplitude de la tension de détection Vd est choisie égale à 5 mV alors que l'amplitude de la tension de commande Vc est de l'ordre de la centaine de volts.

De même, le choix de la fréquence fd de détection permet d'obtenir une réponse plus ou moins prononcée de l'actionneur piézoélectrique 110 à la tension de détection Vd. Préférentiellement, la fréquence fd de détection est inférieure à la fréquence de résonance f0 de l'actionneur piézoélectrique 110. En effet, proche de la fréquence de résonance f0, Vd induit des déformations non souhaitées de par la grande réactivité de l'actionneur piézoélectrique 110 à cette fréquence. Pour des valeurs supérieures à f0, l'amplitude de la déformation de l'actionneur est plus petite mais le courant de détection Id l'est aussi. Ainsi, on choisit de préférence la fréquence fd de détection inférieure à 0.5*f0. Par exemple, pour l'actionneur P 885-91 on a a f0 = 40 kHz. Dans ce cas, la fréquence fd de détection est choisie de préférence inférieure à 20 kHz.

Alternativement, l'amplitude de la tension de détection Vd et/ou la fréquence fd de détection sont sélectionnées pour induire une déformation de l'actionneur piézoélectrique 110 à la fréquence fd de détection présentant une amplitude inférieure à une tolérance prédéterminée, par exemple 1 nm. Ainsi, la déformation de l'actionneur piézoélectrique 110 est liée à titre principale à l'amplitude de la tension de commande Vc.

Une sonde 150 de courant (e.g. une sonde CT6700 commercialisée par la société Hioki) mesure le courant passant via l'électrode 110e. Plus particulièrement, le courant en question se compose, d'une part, d'une composante de courant Ic, dit courant de commande, correspondant à l'application de la tension de commande Vc sur l'électrode 110e et, d'autre part, d'une autre composante de courant Id, dit courant de détection, correspondant à l'application de la tension de détection Vd sur l'électrode 110e.

Le dispositif 130 de correction comprend un dispositif 120 d'estimation de la valeur $\delta$ de la déformation de l'actionneur piézoélectrique 110 liée à l'application de la tension de commande Vc. Plus particulièrement, le dispositif 120 comprend un bloc 120m de mesure délivrant un estimé de l'amplitude de la composante de courant Id. Le dispositif 120 comprend également un bloc 120e d'estimation de la valeur $\delta$ à partir de l'amplitude de la composante de courant Id estimée par le bloc 120m de mesure. De la sorte, le dispositif 120 délivre un estimé $\hat{\delta}$ de la valeur $\delta$ à un bloc 130c de correction de la source de tension 140vc. Sur la base de l'estimé $\hat{\delta}$, le bloc 130c de correction corrige la tension de commande Vc afin d'obtenir une déformation de l'actionneur piézoélectrique 110 correspondant à une déformation cible.

On présente désormais, en relation avec la **Fig. 2** les étapes d'un procédé d'estimation de la déformation de l'actionneur piézoélectrique 110 selon un mode de réalisation de l'invention.

Plus particulièrement, lors d'une étape E210, la tension de détection Vd est appliquée sur l'électrode 110e de contrôle de l'actionneur piézoélectrique 110, en plus de la tension de commande Vc.

Lors d'une étape E220, le courant de détection Id traversant l'électrode 110e à la fréquence fd de détection est mesuré délivrant une amplitude mesurée du courant de détection Id. Plus particulièrement, la fréquence fd de détection est non comprise dans le spectre de la tension de commande afin de pouvoir séparer le courant de détection Id du courant de contrôle Ic.

Dans certains modes de réalisation, le courant de détection Id est ainsi séparé du courant de contrôle Ic via la mise en œuvre d'une transformée de Fourier discrète d'une suite de N échantillons In, n un entier de 0 à N-1, du courant total mesuré par la sonde 150. Par exemple, le courant de détection Id étant à la fréquence fd, seul le point de fréquence fd est calculé afin d'estimer le courant de détection Id. Ainsi, la charge de calcul est réduite. Dans ce cas, le calcul est par exemple effectué selon l'équation :

$$Id = \frac{1}{N}\sum_{n=0}^{N-1} In \, e^{-j2\pi\frac{fd}{fs}} = A + jB$$

avec fs la fréquence d'échantillonnage des N échantillons In du courant total mesuré par la sonde 150. L'amplitude du courant de détection Id est alors donné par le module du nombre complexe $A + jB$.

Dans d'autre modes de réalisation, d'autres techniques de filtrage sont mises en œuvre afin de séparer le courant de détection Id du courant de contrôle Ic (e.g. filtrage passe-bas et passe-haut, etc.).

De retour à la Fig. 2, lors d'une étape E230, la valeur $\delta$ de la déformation de l'actionneur piézoélectrique 110 liée à l'application de la tension de commande Vc est estimée par mise en œuvre d'un estimateur basé sur un mappage préalablement obtenu faisant la correspondance directe, pour la fréquence fd de détection, entre l'amplitude du courant de détection Id et une valeur $\delta$ correspondante de la déformation de l'actionneur piézoélectrique 110. En effet, pour une tension de commande Vc donnée, la déformation obtenue sur l'actionneur piézoélectrique 110 dépend de son état interne. Or, l'impédance vue aux bornes de l'électrode 110e de contrôle est une fonction de l'état interne de l'actionneur piézoélectrique. Ainsi, pour une tension de détection Vd donnée, l'estimation de la valeur $\delta$ de la déformation à partir de l'amplitude du courant de détection Id mesuré permet une prise en compte implicite de l'impédance vue aux bornes de l'électrode 110e de contrôle et donc de l'état interne de l'actionneur piézoélectrique 110 au final. Toutefois, aucun calcul intermédiaire supplémentaire, du type calcul de l'impédance vue aux bornes de l'électrode 110e de contrôle, n'est ici nécessaire.

Par exemple, un tel mappage est obtenu par calibration préalable de l'actionneur piézoélectrique 110, la déformation correspondant à une amplitude de courant de détection Id donnée étant mesurée par un capteur de déplacement (e.g. un capteur LC-2400W commercialisé par la société Keyence).

Dans certains modes de réalisation, un estimateur non-linéaire du type Hammerstein-Weiner est mis en œuvre pour l'estimation de la valeur $\delta$ de la déformation à partir de l'amplitude du courant de détection Id. Ainsi des estimations précises sont obtenues. Cependant, un tel estimateur doit être alimenté par beaucoup de données pour assurer une performance adéquate.

Dans certains modes de réalisation, un estimateur du type OE est mis en œuvre pour l'estimation en question. Un tel estimateur présente en effet un comportement amélioré face à des changement de profil de validation.

Dans certains modes de réalisation, un estimateur du type autorégressifs (e.g. un estimateur ARX (pour « AutoRegressive with eXogenous input » en anglais) ou ARMAX (pour « AutoRegressive Moving Average with eXogenous input » en anglais)) ou du type Box-Jenkins est mis en œuvre.

De retour à la Fig. 2, l'estimateur est appliqué à l'amplitude du courant de détection Id telle que mesurée lors de l'étape E220 et délivre l'estimé $\hat{\delta}$.

On présente désormais, en relation avec la **Fig. 3** les étapes d'un procédé de correction de la déformation de l'actionneur piézoélectrique 110 selon un mode de réalisation de l'invention.

Plus particulièrement, lors d'une étape E300, la tension de commande Vc est appliquée sur l'électrode 110e de contrôle de sorte à induire une déformation de l'actionneur piézoélectrique 110.

Lors d'une phase P1, le procédé d'estimation de la déformation de l'actionneur piézoélectrique 110 tel que décrit ci-dessus (selon l'un quelconque des modes de réalisation précités) est mis en œuvre. De la sorte l'estimé $\hat{\delta}$ de la valeur $\delta$ de la déformation de l'actionneur piézoélectrique 110 est obtenue.

Lors d'une étape E310, une valeur corrigée de la tension de commande Vc est obtenue à partir de l'estimée $\hat{\delta}$ de la valeur de la déformation. Par exemple, lorsque l'estimé $\hat{\delta}$ est représentatif d'une déformation trop importante de l'actionneur piézoélectrique 110 par rapport à une valeur de consigne prédéterminée, la tension de commande Vc est corrigée (réduite ou augmentée) de manière correspondante (e.g. la tension de commande Vc est réduite si la relation entre tension de commande Vc et déformation obtenue présente une pente positive. Réciproquement, la tension de commande Vc est augmentée si la relation entre tension de commande Vc et déformation obtenue présente une pente négative). Une correction inverse est également mise en œuvre lorsque l'estimé $\hat{\delta}$ est représentatif d'une déformation insuffisante de l'actionneur piézoélectrique 110 par rapport à la valeur de consigne (e.g. la tension de commande Vc est augmentée si la relation entre tension de commande Vc et déformation obtenue présente une pente positive. Réciproquement, la tension de commande Vc est réduite si la relation entre tension de commande Vc et déformation obtenue présente une pente négative).

Lors d'une étape E320, la tension de commande Vc corrigée est appliquée sur l'électrode 110e de contrôle. De la sorte, l'actionneur piézoélectrique 110 est mis en position de manière précise.

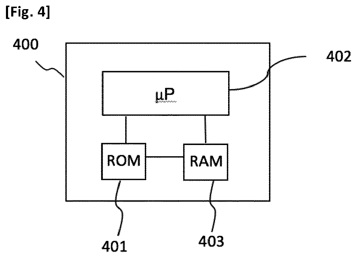

On présente désormais, en relation avec la **Fig. 4** un exemple de structure de dispositif 400 permettant de mettre en œuvre tout ou partie des étapes du procédé d'estimation de la Fig. 2 et/ou du procédé de correction de la Fig. 3 selon un mode de réalisation de l'invention.

Le dispositif 400 comprend une mémoire vive 403 (par exemple une mémoire RAM), une unité de traitement 402 équipée par exemple d'un processeur, et pilotée par un programme d'ordinateur stocké dans une mémoire morte 401 (par exemple une mémoire ROM ou un disque dur). A l'initialisation, les instructions de code du programme d'ordinateur sont par exemple chargées dans la mémoire vive 403 avant d'être exécutées par le processeur de l'unité de traitement 402.

Cette Fig. 4 illustre seulement une manière particulière, parmi plusieurs possibles, de réaliser le dispositif 400 afin qu'il effectue tout ou partie des étapes du procédé d'estimation de la Fig. 2 et/ou du procédé de correction de la Fig. 3 (selon l'un quelconque des modes de réalisation précités). En effet, ces étapes peuvent être réalisées indifféremment sur une machine de calcul reprogrammable (un ordinateur PC, un processeur DSP ou un microcontrôleur) exécutant un programme comprenant une séquence d'instructions, ou sur une machine de calcul dédiée (par exemple un ensemble de portes logiques comme un FPGA ou un ASIC, ou tout autre module matériel).

Dans le cas où le dispositif 400 est réalisé avec une machine de calcul reprogrammable, le programme correspondant (c'est-à-dire la séquence d'instructions) pourra être stocké dans un médium de stockage amovible (tel que par exemple un CD-ROM, un DVD-ROM, une clé USB) ou non, ce médium de stockage étant lisible partiellement ou totalement par un ordinateur ou un processeur.

Dans certains modes de réalisation, le dispositif 400 est inclus dans le système 100 actionneur.

## Revendications

**1.** Procédé d'estimation (P1) d'une déformation d'un actionneur piézoélectrique (110), ladite déformation résultant d'une application d'une tension de commande (Vc) sur au moins une électrode (110e) de contrôle dudit actionneur piézoélectrique, ledit procédé comprenant :

     - une application (E210) d'une tension de détection (Vd) sur ladite au moins une électrode de contrôle, une fréquence de ladite tension de détection, dite fréquence de détection, étant non comprise dans un spectre de ladite tension de commande ; et
     - une mesure (E220) d'un courant de détection (Id) traversant ladite au moins une électrode de contrôle à ladite fréquence de détection délivrant une amplitude mesurée dudit courant de détection,

     **caractérisé en ce qu**'il comprend une estimation (E230) de ladite déformation par mise en œuvre d'un estimateur basé sur un mappage préalablement obtenu faisant la correspondance directe, pour ladite fréquence de détection, entre au moins une amplitude dudit courant de détection et une valeur correspondante de ladite déformation dudit actionneur piézoélectrique, ledit estimateur étant appliqué à ladite amplitude mesurée dudit courant de détection.

**2.** Procédé d'estimation selon la revendication 1 dans lequel ladite mesure d'un courant de détection met en œuvre une transformée de Fourier discrète d'une série de N échantillons temporels dudit courant de détection.

3. Procédé d'estimation selon la revendication 2 dans lequel ladite transformée de Fourier discrète est évaluée uniquement à ladite fréquence de détection.

4. Procédé d'estimation selon l'une quelconque des revendications 1 à 3 dans lequel ledit estimateur est un estimateur linéaire du type OE (pour « Output Error » en anglais) ou un estimateur non-linéaire du type Harmmerstein-Wiener.

5. Procédé d'estimation selon l'une quelconque des revendications 1 à 4 dans lequel ladite fréquence de détection est différente d'une fréquence de résonance f0 dudit actionneur piézoélectrique, de préférence ladite fréquence de détection est inférieure à 0,5 * f0.

6. Procédé d'estimation selon l'une quelconque des revendications 1 à 5 dans lequel une amplitude de ladite tension de détection est configurée pour induire une déformation dudit actionneur piézoélectrique à ladite fréquence de détection présentant une amplitude inférieure à une tolérance prédéterminée.

7. Procédé de correction d'une déformation d'un actionneur piézoélectrique (110),
**caractérisé en ce qu'**il comprend :

- une application (E300) d'une tension de commande (Vc) sur au moins une électrode (110e) de contrôle dudit actionneur piézoélectrique induisant ladite déformation ;
- une estimation de ladite déformation par mise en œuvre d'un procédé d'estimation (P1) selon l'une quelconque des revendications 1 à 6 suite à ladite application de la tension de commande ;
- une correction (E310) de ladite tension de commande à partir de ladite estimation de ladite déformation délivrant une tension de commande corrigée ; et
- une application (E320) de ladite tension de commande corrigée sur ladite au moins une électrode de contrôle.

8. Produit programme d'ordinateur comprenant des instructions de code de programme pour la mise en œuvre d'un procédé selon l'une quelconque des revendications 1 à 7, lorsque ledit programme est exécuté sur un ordinateur.

9. Dispositif (120, 400) d'estimation d'une déformation d'un actionneur piézoélectrique (110), ladite déformation résultant d'une application d'une tension de commande (Vc) sur au moins une électrode (110e) de contrôle dudit actionneur piézoélectrique, ledit dispositif comprenant une machine de calcul reprogrammable (402) ou une machine de calcul dédiée, configurée pour :

- appliquer une tension de détection (Vd) sur ladite au moins une électrode de contrôle, une fréquence de ladite tension de détection, dite fréquence de détection, étant non comprise dans un spectre de ladite tension de commande ; et
- mesurer un courant de détection (Id) traversant ladite au moins une électrode de contrôle à ladite fréquence de détection délivrant une amplitude mesurée dudit courant de détection,

**caractérisé en ce que** ladite machine de calcul reprogrammable (402) ou ladite machine de calcul dédiée est configurée pour estimer ladite déformation par mise en œuvre d'un estimateur basé sur un mappage préalablement obtenu faisant la correspondance directe, pour ladite fréquence de détection, entre au moins une amplitude dudit courant de détection et une valeur correspondante de ladite déformation dudit actionneur piézoélectrique, ledit estimateur étant appliqué à ladite amplitude mesurée dudit courant de détection.

10. Dispositif (130, 400) de correction d'une déformation d'un actionneur piézoélectrique
**caractérisé en ce qu'**il comprend une machine de calcul reprogrammable (402) ou une machine de calcul dédiée, configurée pour :

- appliquer une tension de commande (Vc) sur au moins une électrode (110e) de contrôle dudit actionneur piézoélectrique induisant ladite déformation ;
- estimer ladite déformation par mise en œuvre d'un procédé d'estimation (P1) selon l'une quelconque des revendications 1 à 6 suite à ladite application de la tension de commande ;
- corriger ladite tension de commande à partir de ladite estimation de ladite déformation délivrant une tension de commande corrigée ; et
- appliquer ladite tension de commande corrigée sur ladite au moins une électrode de contrôle.

11. Système (100) actionneur asservi en déformation comprenant au moins un actionneur piézoélectrique (110) associé à un dispositif (130, 400) de correction selon la revendication 10.

[Fig. 1]

[Fig. 2]

[Fig. 3]

[Fig. 4]

400

402

μP

ROM —— RAM

401    403

Europäisches
Patentamt

European
Patent Office

Office européen
des brevets

**RAPPORT DE RECHERCHE EUROPEENNE**

Numéro de la demande

EP 19 21 6194

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 5 661 359 A (KATSURAGAWA MITSUHIRO [JP]) 26 août 1997 (1997-08-26) * colonne 2, ligne 65 - colonne 3, ligne 55; figure 1 * ----- | 1-11 | INV. H01L41/04 |
| A | WO 2013/140102 A1 (UNIV FRANCHE COMTE [FR]; ECOLE NALE SUP ARTES METIERS [FR]) 26 septembre 2013 (2013-09-26) * alinéas [0005] - [0025] * ----- | 1-11 | |
| A | EP 1 737 114 A1 (SEIKO EPSON CORP [JP]) 27 décembre 2006 (2006-12-27) * alinéas [0035] - [0045]; figures 3,4 * ----- | 1-11 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| Munich | 15 juillet 2020 | Steiner, Markus |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
...................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 21 6194

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-07-2020

| Document brevet cité au rapport de recherche | | Date de publication | Membre(s) de la famille de brevet(s) | | Date de publication |
|---|---|---|---|---|---|
| US 5661359 | A | 26-08-1997 | JP | 3382405 B2 | 04-03-2003 |
|  |  |  | JP | H08214570 A | 20-08-1996 |
|  |  |  | US | 5661359 A | 26-08-1997 |
| WO 2013140102 | A1 | 26-09-2013 | EP | 2828968 A1 | 28-01-2015 |
|  |  |  | FR | 2988518 A1 | 27-09-2013 |
|  |  |  | US | 2015054520 A1 | 26-02-2015 |
|  |  |  | WO | 2013140102 A1 | 26-09-2013 |
| EP 1737114 | A1 | 27-12-2006 | CN | 1898855 A | 17-01-2007 |
|  |  |  | EP | 1737114 A1 | 27-12-2006 |
|  |  |  | HK | 1100594 A1 | 16-12-2011 |
|  |  |  | JP | 4293189 B2 | 08-07-2009 |
|  |  |  | JP | 4883074 B2 | 22-02-2012 |
|  |  |  | JP | 2009027920 A | 05-02-2009 |
|  |  |  | JP | WO2005086337 A1 | 09-08-2007 |
|  |  |  | US | 2007278976 A1 | 06-12-2007 |
|  |  |  | WO | 2005086337 A1 | 15-09-2005 |

EPO FORM P0460

Pour tout renseignement concernant cette annexe : voir Journal Officiel de l'Office européen des brevets, No.12/82